# DEMANDE DE BREVET EUROPEEN

(11) **EP 4 286 872 A1**
(43) Date de publication de la demande: **06.12.2023**
(21) Numéro de dépôt: 23175099.3
(22) Date de dépôt: 24.05.2023
(51) Int. Cl.: G01R 31/392, G06F 18/213, H03M 7/30

(54) **PROCÉDÉ DE GÉNÉRATION D'UN PROFIL DE SOLLICITATION ALLÉGÉ À PARTIR D'UN PROFIL DE SOLLICITATION D'UNE BATTERIE**

(30) Priorité: 01.06.2022 FR 2205297
(71) Demandeur: Commissariat à l'énergie atomique et aux énergies alternatives, 75015 Paris (FR)
(72) Inventeur: DOLLFUS, Tom, 38054 GRENOBLE (FR); MONTARU, Maxime, 38054 GRENOBLE (FR)
(74) Mandataire: Cabinet Nony

(57) **Abrégé**

L'invention concerne un procédé mis en oeuvre par ordinateur pour générer un profil allégé à partir d'un profil initial de sollicitation d'une batterie comportant une pluralité d'entrées renseignant sur l'évolution temporelle d'une pluralité de paramètres, comprenant les étapes consistant à :
(a) affecter à chaque paramètre du profil initial une classe correspondant à un intervalle de valeurs possibles dudit paramètre ;
(b) grouper chaque ensemble formé d'entrées ayant les mêmes combinaisons de classes de paramètres et déterminer une durée correspondante ;
(c) redéfinir chaque valeur des paramètres de chaque entrée pour être égale à une valeur caractéristique de la classe correspondante ;
(d) créer le profil allégé avec les valeurs des paramètres du profil obtenu à l'étape (c) ainsi qu'un temps cumulé.

## Description

### Domaine technique

La présente invention concerne le domaine de l'étude du vieillissement de générateurs électrochimiques, plus particulièrement du vieillissement d'accumulateurs électrochimiques tels que des batteries lithium-ion.

### Technique antérieure

L'étude des mécanismes de vieillissement physico-chimiques d'une batterie, par exemple au lithium, est complexe dans la mesure où les causes du vieillissement sont multiples.

Les mécanismes de vieillissement se produisent pendant les phases d'usage de la batterie (vieillissement dit en cyclage) ainsi qu'en raison du passage du temps, que ce soit en phase d'usage ou en phase de repos (vieillissement dit calendaire).

Le vieillissement en cyclage est influencé par de nombreux paramètres, tels que la température, la variation de l'état de charge de la batterie, la forme de courant appliquée, etc. Le vieillissement en cyclage dépend fortement de l'usage.

Le vieillissement calendaire dépend essentiellement de la température et de l'état de charge.

Dans le cadre de l'étude du vieillissement de batteries, il est connu de leur appliquer des profils temporels déterminés de charge et décharge, les profils comportant éventuellement des phases à courant nul. La forme des profils de charge et décharge appliqués dépend notamment de l'utilisation de la batterie que l'on veut étudier.

Les paramètres de charge et de décharge ainsi que les données mesurées lors de ces phases de tests constituent un profil de sollicitation pouvant être utilisé en entrée d'un modèle de vieillissement de batterie.

Un profil de sollicitation configuré pour être utilisé par un modèle de vieillissement peut notamment comprendre l'état de charge du dispositif (SOC, en anglais « *state of charge* »), sa température T, l'intensité 1 du courant consommé ou produit par le dispositif et la profondeur de décharge (DOD, en anglais « *depth of discharge* »)*.*

Le profil obtenu peut servir au suivi régulier du vieillissement d'une batterie à partir de données d'exploitation. Dans ce cas, le profil est régulièrement mis à jour.

Le profil obtenu peut également être utilisé dans un modèle de vieillissement afin de simuler le vieillissement des batteries sur des intervalles de temps longs. La simulation du vieillissement permet d'extrapoler les sollicitations des batteries testées sur plusieurs années et de prédire une évolution des paramètres de la batterie.

Plusieurs modèles de vieillissement existent, par exemple tels que décrits dans les publications suivantes : « Lithium Battery Aging Model Based on Dakin's Degradation Approach », Baghdadi, Issam, Olivier Briat, Jean-Yves Delétage, Philippe Gyan, et Jean-Michel Vinassa. Journal of Power Sources 325 (septembre 2016) : 273 85 ; « Calendar and Cycling Ageing Combination of Batteries in Electric Vehicles », Redondo-Iglesias, Eduardo, Pascal Venet, et Serge Pelissier. Microelectronics Reliability 88 90 (septembre 2018) : 1212 15; « Main Aging Mechanisms in Li Ion Batteries », Broussely, M., Ph. Biensan, F. Bonhomme, Ph. Blanchard, S. Herreyre, K. Nechev, et R.J. Staniewicz. Journal of Power Sources 146, no 12 (août 2005): 90 96.

Les simulations de vieillissement sont sources de nombreux calculs et requièrent donc des puissances de calcul relativement élevées. En effet, les calculs se font typiquement par itérations successives pour chaque pas de temps du profil d'entrée. Les profils d'entrée comportent une quantité significative de données car ce sont typiquement des séries temporelles comportant une quantité de données proportionnelle à la durée des profils. Le stockage d'un nombre important de profils d'entrée peut ainsi nécessiter une mémoire de grande capacité.

Il existe donc un besoin pour minimiser les temps de calcul des simulations de vieillissement de batteries et les ressources nécessaires, notamment en termes de puissance de calcul et de quantité de mémoire requise.

Le but de l'invention est de répondre au moins en partie à ce besoin.

### Exposé de l'invention

Pour ce faire, l'invention concerne selon un de ses aspects un procédé mis en oeuvre par ordinateur pour générer à partir d'un profil initial de sollicitation d'une batterie un profil allégé, le profil initial comportant une pluralité d'entrées renseignant sur l'évolution temporelle d'une pluralité de paramètres de la batterie, le procédé comprenant les étapes consistant à :
(a) affecter à chaque valeur de chaque paramètre du profil initial une classe correspondant à un intervalle de valeurs possibles dudit paramètre ;
(b) grouper chaque ensemble formé d'entrées ayant les mêmes combinaisons de classes de paramètres en une entrée unique et déterminer, pour chaque entrée du profil obtenu, une durée correspondant à la somme des durées des entrées groupées ;
(c) redéfinir les valeurs des paramètres de chaque entrée, une valeur de paramètre étant redéfinie pour être égale à une valeur caractéristique de la classe correspondant à ladite valeur de paramètre ;
(d) créer le profil allégé en prenant pour chaque entrée du profil allégé les valeurs des paramètres du profil obtenu à l'étape (c) ainsi qu'un temps cumulé, le temps cumulé de la première entrée étant initialisé à une valeur de référence et le temps cumulé de chaque entrée suivante étant déterminé par la somme de la durée correspondant à l'entrée précédant ladite entrée suivante et du temps cumulé de l'entrée précédant ladite entrée suivante.

Par « mis en oeuvre par ordinateur » il faut comprendre que les calculs sont effectués par tout système informatique disposant d'un processeur adapté, par exemple un micro-ordinateur, un microcontrôleur, un FPGA, un circuit électronique spécialisé, etc...

Par « état de charge » ou « SOC », on entend dans le cadre de l'invention le niveau de charge d'une batterie en fonction de sa capacité. L'état de charge est exprimé en pourcentage pour des conditions nominales de charge et décharge déterminées. Un état de charge de 0% indique que la batterie est vide et un état de charge de 100% indique que la batterie est pleine. Dans certains cas, les conditions d'utilisation permettent de recharger ou décharger plus profondément la batterie. La valeur de l'état de charge peut donc dépasser 100% ou être inférieure à 0%.

Par « profondeur de décharge » ou « DOD », on entend dans le cadre de l'invention une valeur représentant l'évolution continue du SOC au cours d'un même cycle de charge ou de décharge.

Le procédé selon l'invention permet l'obtention de profils allégés de taille réduite par rapport aux profils de sollicitation d'origine.

Ces profils allégés peuvent être utilisés pour mettre en oeuvre des simulations de vieillissement significativement plus rapidement qu'avec les profils d'origine. Leur taille réduite signifie également que le stockage d'un nombre important de profils est facilité. Cela est notamment important dans le cas d'applications embarquées pour lesquelles les capacités de calcul et/ou de stockage sont limitées, comme pour le suivi de l'état d'une batterie par un système de gestion de batterie BMS (« Battery Management System » en anglais) ou un système de gestion d'énergie EMS (« Energy Management System »). Cela est également avantageux pour des applications de suivi de vieillissement d'installations industrielles de stockage stationnaire d'énergie par batteries.

L'invention permet donc de réduire la taille des données stockées pour des suivis de vieillissement de batteries et de permettre des études de vieillissement rapides avec des capacités de calcul limitées.

Le procédé selon l'invention peut encore comporter une ou plusieurs des caractéristiques optionnelles suivantes :
- la valeur caractéristique d'une classe pour un paramètre donné est choisie parmi une borne inférieure de la classe, une borne supérieure de la classe, une moyenne de la borne inférieure et de la borne supérieure de la classe ou est déterminée à partir des valeurs dudit paramètre donné comprises dans ladite classe ;
- le procédé comprend entre l'étape (c) et l'étape (d) une étape (c1) consistant à créer une matrice de distribution temporelle en enregistrant la durée de chaque entrée en fonction des classes de chaque paramètre de ladite entrée ;
- les paramètres comprennent au moins un paramètre cumulatif, le procédé comprenant entre l'étape (a) et l'étape (b) une étape (a1) consistant à rééchantillonner le profil en cas de variation d'une classe de paramètre cumulatif supérieure à un seuil donné entre deux entrées consécutives ;
- les paramètres comprennent une intensité consommée ou produite par la batterie, le procédé comprenant en outre :
   o avant l'étape (b), une étape (a2) consistant à calculer, pour chaque entrée, une valeur de quantité de charge transitée définie par la valeur de l'intensité de ladite entrée multipliée par la durée de ladite entrée ;
   o entre les étapes (b) et (c), une étape (b1) consistant à déterminer, pour chaque entrée du profil obtenu suite à l'étape de groupement, la valeur de quantité de charge transitée correspondante ;
- le procédé comprend en outre entre les étapes (c) et (d), une étape (c2) consistant à créer une matrice de distribution de quantité de charge transitée en enregistrant la valeur de quantité de charge transitée de chaque entrée en fonction des classes de chaque paramètre ;
- on calcule au cours de l'étape (c) une intensité moyenne pour chaque entrée à partir de la quantité de charge transitée et de la durée de ladite entrée ;
- les paramètres comprennent un état de charge de la batterie, une température de la batterie et une profondeur de décharge de la batterie ;
- les entrées du profil obtenu à l'étape (b) sont ordonnées en parcourant en premier lieu les classes d'état de charge ;
- les paramètres comprennent une intensité consommée ou produite par la batterie, les entrées du profil obtenu à l'étape (b) étant ordonnées en parcourant en second lieu les classes de température, puis les classes d'intensité, puis les classes de profondeur de décharge de la batterie ;
- le procédé comporte avant l'étape (a) une étape (a0) consistant à générer le profil de sollicitation initial, notamment par suivi des paramètres de la batterie lors d'une application industrielle ou lors d'un test comprenant des étapes de vieillissement en cyclage et de vieillissement calendaire ;
- les étapes (a) et (b) sont appliquées à une pluralité de profils initiaux de sollicitation et les étapes (c) et (d) sont appliquées en une fois aux entrées uniques du profil obtenu suite à l'étape (b).

L'invention concerne également un procédé de simulation de vieillissement d'une batterie, dans lequel on génère une information relative à une prédiction du vieillissement de la batterie à partir d'un profil allégé obtenu par la mise en oeuvre du procédé pour générer un profil allégé selon l'invention.

L'invention concerne enfin un produit programme d'ordinateur comportant un support informatique et, enregistrées sur ce support, des instructions lisibles par un processeur amenant ce dernier, lorsqu'exécutées, mettre en oeuvre le procédé pour générer un profil allégé selon l'invention pour obtenir un profil allégé.

### Brève description des dessins

[Fig 1] La figure 1 illustre un procédé de génération d'un profil allégé selon l'invention.
[Fig 2] La figure 2 est un graphique comparant des valeurs d'état de santé d'une batterie obtenues à partir d'un profil de sollicitation initial et d'un profil allégé obtenu par le procédé selon l'invention.
[Fig 3] La figure 3 est une vue de détail de la figure 1.

### Description détaillée

Le procédé selon l'invention permet d'obtenir un profil allégé à partir d'un profil de sollicitation d'une batterie.

Un profil de sollicitation type est défini pour une application donnée. Ce profil type est généralement issu d'un ou plusieurs tests sur une batterie réalisés dans le cadre d'une application batterie donnée. Un test consiste en l'application pendant un temps déterminé, pouvant notamment être de plusieurs semaines ou de plusieurs mois, d'un ensemble de charges et de décharges représentatif de l'usage de la batterie dans une application déterminée. Durant la phase de test, on mesure plusieurs paramètres représentatifs de l'état de la batterie. Le résultat de ces mesures forme une table de valeurs appelée profil de sollicitation de la batterie.

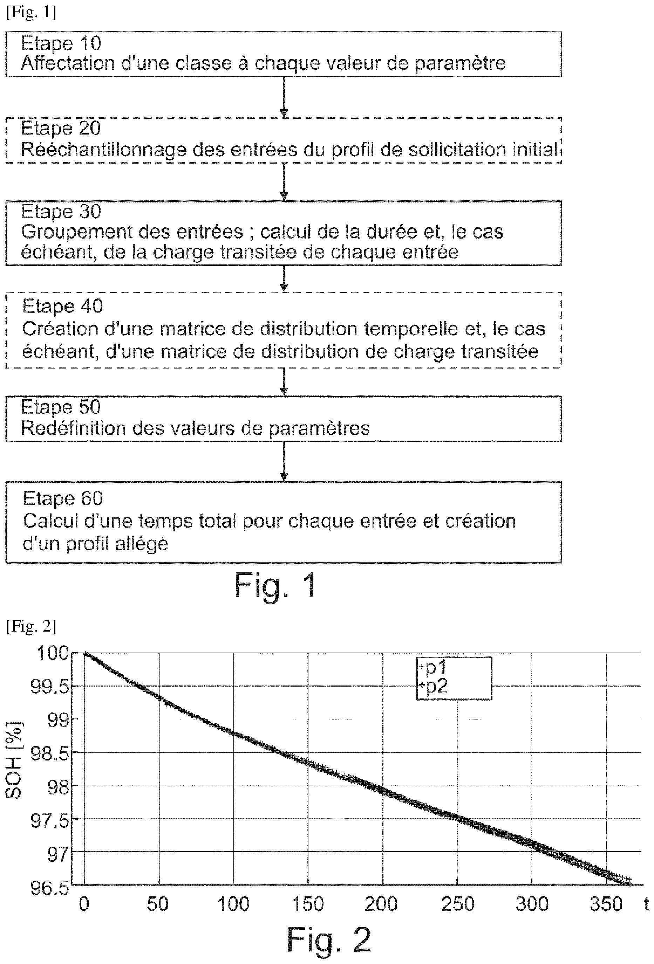

On a illustré à la figure 1 les étapes d'un procédé selon l'invention, dans laquelle les cadres en pointillés indiquent les étapes optionnelles du procédé.

Dans un exemple de mise en oeuvre du procédé selon l'invention, les paramètres du profil de sollicitation initial sont l'intensité du courant consommé ou produit par la batterie, la température de la batterie, son état de charge et sa profondeur de décharge. En fonction notamment des facteurs de vieillissement des modèles de batterie considérés, certains de ces paramètres peuvent être ignorés et d'autres paramètres peuvent être considérés. Les sensibilités des modèles de vieillissement à différents paramètres sont différentes pour chaque technologie de batterie et dépendent notamment de la chimie constitutive des batteries.

On a représenté dans le tableau 1 un exemple de données provenant d'un profil de sollicitation de batterie. Ce profil représente l'évolution temporelle des quatre paramètres mentionnés.

L'état de charge (SOC), la température T et l'intensité 1 sont directement mesurés en opération. La profondeur de décharge (DOD) est calculée à partir des données mesurées. Dans le présent exemple de mise en oeuvre du procédé selon l'invention, le calcul du DOD est basé sur l'analyse de la profondeur de charge ou de décharge sur un cycle de charge ou de décharge respectivement, la fin d'un cycle étant détectée selon les fluctuations de l'intensité.

Ainsi, comme illustré dans le tableau 1, pour chaque pas du profil temporel, le DOD est incrémenté progressivement en fonction de l'évolution du SOC : si le SOC augmente ou diminue d'un certain nombre de points de pourcentage, le DOD augmente de ce même nombre de points de pourcentage. Le DOD est réinitialisé à une valeur de 0% lorsque le courant devient nul (correspondant à un arrêt du cycle de charge ou de décharge) ou à un changement de signe du courant (correspondant à une transition d'un cycle de charge à un cycle de décharge ou vice-versa).

Selon une alternative de calcul de profondeur de décharge, la valeur du DOD pendant un cycle de charge ou de décharge est constante et égale à la variation totale du SOC pendant l'intégralité de ce cycle de charge ou de décharge. Le DOD est réinitialisé lorsque le courant devient nul (correspondant à un arrêt du cycle de charge ou de décharge) ou change de signe.

Afin de ne pas perturber le calcul de la profondeur de décharge par exemple par des microcycles de charge ou de décharge, par du bruit ou par des erreurs de mesures, un filtrage du courant peut être mis en place. Le filtrage de courant permet de lisser les éventuelles déviations de courant de courte durée. Une déviation de courant peut consister en un passage à 0 A de façon brève ou en un changement de signe du courant de façon brève.

Le profil comporte une pluralité d'entrées, arrangées par exemple par ordre chronologique croissant correspondant à la chronologie des mesures. Chaque entrée comporte une valeur de chacun des paramètres, chaque valeur étant associée à un temps. Les temps comportent chacun une date et une heure.

On considère qu'une valeur de paramètre associée à un temps donné est constante entre ce temps et le temps correspondant à l'entrée suivante. A titre d'exemple, on peut lire dans le tableau 1 qu'une intensité de 120 A est appliquée de 01h15 à 01h16 le 01/01/2021. L'intensité est donc supposée être restée constante à cette valeur pendant une minute.

Ainsi, la durée pendant laquelle les conditions correspondant à une entrée donnée sont maintenues constantes est calculée par la différence entre le temps associé à l'entrée suivant cette entrée et le temps de cette entrée.

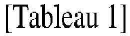

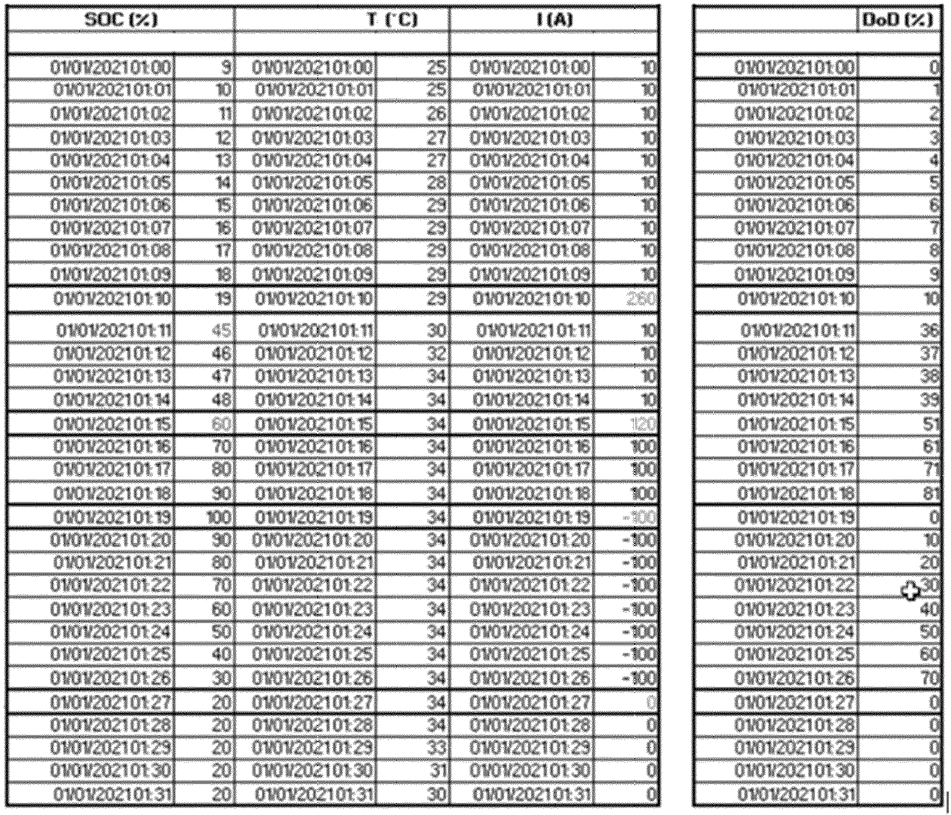

Dans une première étape du procédé selon l'invention (étape 10), on définit pour chaque paramètre du profil une pluralité de classes. Chaque classe correspond à un intervalle de valeurs possibles du paramètre concerné. Les différents intervalles de valeurs pour un paramètre donné forment ensemble un intervalle continu de valeurs, sans qu'il n'y ait de chevauchement entre deux intervalles.

Les classes sont définies pour permettre la reproduction du profil de sollicitation. En particulier, on veille à ce que les classes soient suffisamment fines, ou autrement dit que la largeur des intervalles de valeurs définissant les classes soit suffisamment faible. Le degré désiré de finesse des classes dépend du type d'étude de vieillissement menée. Par exemple, on a dix classes pour couvrir une gamme 0 à 100 points, par intervalles de 10 points.

On a par exemple entre 5 et 20 classes pour le paramètre SOC, entre 10 et 40 classes pour le paramètre d'intensité, entre 1 et 5 classes pour le paramètre température, et autant de classes pour le paramètre DOD que le paramètre SOC.

A titre d'exemple, les classes correspondant aux quatre paramètres du tableau 1 peuvent être définies de la manière illustrée dans le tableau 2. La finesse des classes présentées dans le tableau 2 est adaptée à des études de vieillissement de technologies de batteries lithium ion sur plusieurs années. Selon la dynamique du profil de sollicitation, on appréciera une finesse plus ou moins élevée des classes considérées. Par exemple, pour un profil de cyclage sollicitant la batterie entre 10 et 20% de SOC, on privilégiera une finesse des classes par pas d'un point de SOC plutôt que 10 points de SOC comme illustré dans le tableau 2.

**[Tableau 2]**

| | |
|---|---|
| Classes de SOC (%) | [0,10[ ; [10,20[ ; [20,30[ ; [30,40[ ; [40,50[ ; [50,60[ ; [60,70[ ; [70,80[ ; [80,90[ ; [90,100[ ; [100,110] |
| Classes d'intensité (A) | [-110,-100[ ; [-100,-90[ ; [-90,-80[ ; [-80,-70[ ; [-70,-60[ ; [-60,-50[ ; [-50,-40[ ; [-40,-30[ ; [-30,-20[ ; [-20,-10[ ; [-10,0[ ; [0,10[ ; [10,20[ ; [20,30[ ; [30,40[ ; [40,50[ ; [50,60[ ; [60,70[ ; [70,80[ ; [80,90[ ; [90,100[ ; [100,110[ ; [110,120[ ; [120,130[ ; [130,140[ ; [140,150[ ; [150,160[ ; [160,170[ ; [170,180[ ; [180,190[ ; [190,200[ ; [200,210[ ; [210,220[ ; [220,230[ ; [230,240[ ; [240,250[ ; [250,260[ ; [260,270] |
| Classes de température (°C) | [25,30[ ; [30,35] |
| Classes de DOD (%) | [0,10[ ; [10,20[ ; [20,30[ ; [30,40[ ; [40,50[ ; [50,60[ ; [60,70[ ; [70,80[ ; [80,90[ ; [90,100[ ; [100,110] |

On a illustré dans le tableau 3 les classes correspondant aux valeurs de paramètres des entrées du profil du tableau 1. On constate à titre d'exemple que la classe de l'état de charge correspondant au temps de 01h11 est [40%,50%[ : cela correspond à la valeur d'état de charge de 45% à ce temps tel qu'indiqué dans le tableau 1.

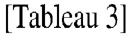

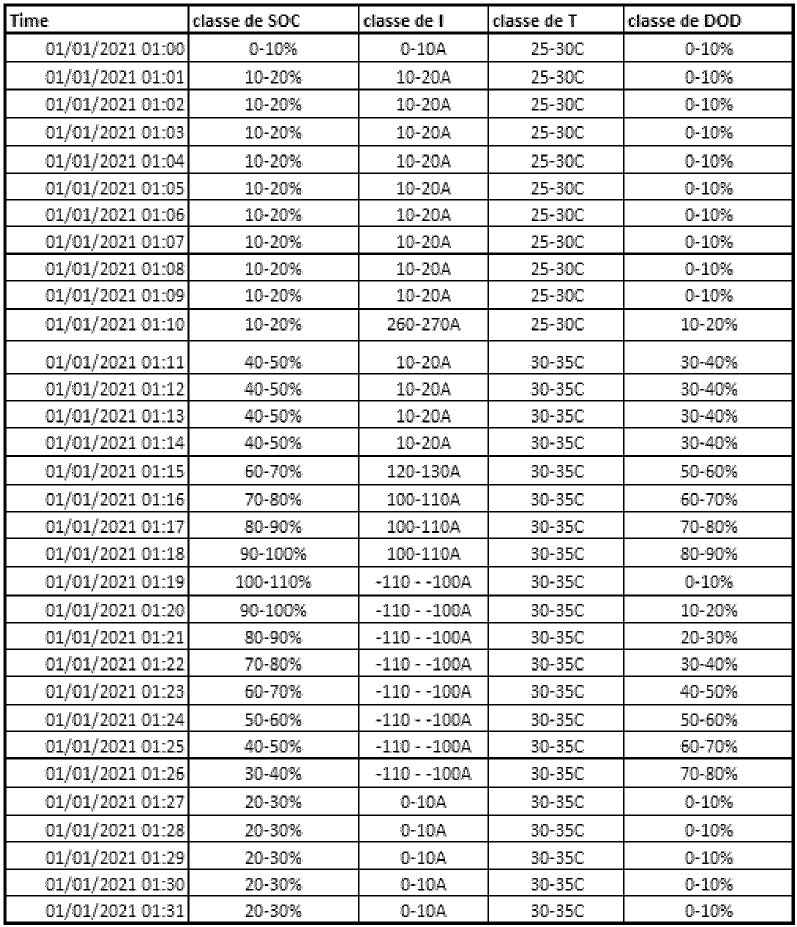

On observe dans certains cas des variations rapides de valeurs de paramètres. On considère que l'on observe une variation rapide lorsque deux entrées consécutives ont des classes de paramètres dont les intervalles de valeurs ne sont ni identiques ni consécutifs ou, autrement dit, lorsqu'il existe des classes intermédiaires entre les classes de deux entrées consécutives.

Dans ce cas, il peut être avantageux de rééchantillonner les entrées correspondant à ces variations rapides de sorte que l'on obtienne au moins une valeur de paramètre dans chaque classe intermédiaire entre les classes des deux entrées successives (étape 20).

Le rééchantillonnage consiste donc à créer de nouvelles entrées entre deux entrées successives pour éviter que ces deux entrées successives comportent des classes dont les intervalles de valeurs sont éloignés l'un de l'autre. Autrement dit, le rééchantillonnage permet d'avoir au moins un point dans chaque classe traversée lors de la sollicitation.

Un tel rééchantillonnage n'est de préférence réalisé que pour les paramètres cumulatifs, c'est-à-dire l'état de charge et la température dans cet exemple. On assigne aux autres paramètres, pour les nouvelles entrées créées par le rééchantillonnage, la valeur du paramètre de la première des deux entrées successives. On procède de cette manière en particulier pour l'intensité.

Par « paramètre cumulatif » ou « paramètre continu », on entend un paramètre dont l'évolution temporelle est lente. Par exemple, l'état de charge et la température évoluent de manière progressive et lente même en cas de sollicitations variables et constituent des paramètres cumulatifs. A contrario, l'intensité peut varier très rapidement entre courant de charge maximal et courant de décharge maximal et n'est donc pas un paramètre cumulatif.

On considère par exemple que, pour un profil de sollicitation donné dans lequel les valeurs d'un paramètre varient entre un maximum et un minimum, ce paramètre est cumulatif si l'évolution de ce paramètre est systématiquement inférieure à 10% de la différence entre le maximum et le minimum par seconde.

Les valeurs de paramètres des entrées après rééchantillonnage sont considérées comme étant constantes entre deux entrées consécutives.

On observe par exemple dans le tableau 3 que la classe d'état de charge est [10%,20%[ à 01h10, correspondant à la valeur d'état de charge de 19%, et [40%,50%[ à 01h11, correspondant à la valeur d'état de charge de 45%. Cela représente une variation rapide de la classe d'état de charge puisque les deux entrées successives ont des classes dont les intervalles de valeurs ne sont pas consécutifs.

On introduit alors avantageusement des entrées intermédiaires pour obtenir au moins un point dans chaque classe entre les classes [10%,20%[ et [40%,50%[.

Les valeurs intermédiaires sont par exemple choisies pour être chacune égale à une borne inférieure d'un intervalle d'une classe intermédiaire entre les classes [10%,20%[ et [40%,50%[. On peut également assigner à ces valeurs intermédiaires toute valeur appartenant à un intervalle d'une classe intermédiaire. Les temps des nouvelles entrées correspondantes peuvent notamment être déterminés par interpolation linéaire des temps des deux entrées successives du profil de sollicitation initial.

Les entrées du tableau 3 rééchantillonnées sont représentées dans le tableau 4. Trois nouvelles entrées ont été créées entre les entrées de 01h10 et de 01h11. Les valeurs d'état de charge de ces trois entrées sont choisies pour être chacune égale à une borne inférieure d'un intervalle d'une classe intermédiaire entre les classes des entrées de 01h10 et de 01h1 : il s'agit dans cet exemple de 20%, 30% et 40%. Une interpolation linéaire peut être utilisée pour déterminer les temps des entrées nouvellement créées. On note à cet effet que la valeur d'état de charge passe de 19% à 45% en une minute entre 01h10 et 01h11, ce qui correspond à une variation d'environ 0,433 point de pourcentage par seconde. Le temps assigné à la valeur d'état de charge de 20%, correspondant à une différence d'un point de pourcentage avec la valeur de 01h10, est donc de 1/0,433 soit environ deux secondes. De même, le temps assigné à la valeur d'état de charge de 30%, soit une différence de 11 points de pourcentage avec la valeur de 01h10, est de 11/0,433 soit environ 25 secondes.

De manière avantageuse, l'étape de rééchantillonnage permet de garantir une évolution progressive des paramètres continus.

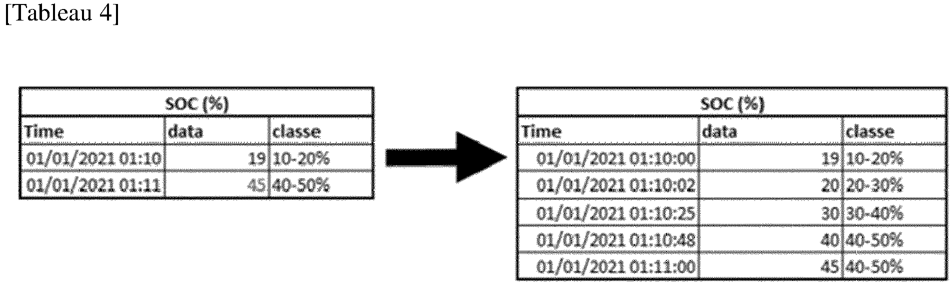

Pour chaque entrée après rééchantillonnage, on calcule une quantité de charge transitée, notée Qth et égale à l'intensité d'une entrée multipliée par la différence entre le temps de l'entrée temporellement consécutive à cette entrée et le temps de cette entrée, c'est-à-dire la durée de cette entrée.

Dans une étape suivante du procédé selon l'invention (étape 30), on groupe toutes les entrées ayant une même combinaison de classes de paramètres, qu'elles soient temporellement consécutives ou non. On calcule ensuite, pour chaque entrée obtenue suite à l'opération de groupement, la durée correspondante, c'est-à-dire le temps cumulé passé dans les conditions caractérisées par les classes des paramètres, ainsi que la quantité de charge transitée.

La durée, ou temps cumulé, est notée Δt.

La quantité de charge transitée Qth d'un groupement d'entrées est égale à la somme des quantités de charge transitée de chacune des entrées groupées dans ce groupement d'entrées.

Le calcul de la quantité de charge transitée pour chaque entrée permet de garantir que la quantité de charge transitée tout au long du profil de sollicitation initial est respectée, ce qui est particulièrement important pour assurer la qualité d'une étude de vieillissement utilisant le profil allégé obtenu par le procédé selon l'invention.

A partir des entrées du tableau 3 rééchantillonnées, on obtient suite à l'opération de groupement et de calcul de durée et de quantité de charge transitée les entrées illustrées dans le tableau 5.

**[Tableau 5]**

| **classe de SOC** | **classe de I** | **classe de T** | **classe de DOD** | **Delta t (h)** | **Q (Ah)** |
|---|---|---|---|---|---|
| 0-10% | 10-20A | 25-30C | 0-10% | 0.016666667 | 0.16665667 |
| 10-20% | 10-20A | 25-30C | 0-10% | 0.150 | 1.500 |
| 10-20% | 260-270A | 25-30C | 10-20% | 0.000555556 | 0.14444444 |
| 20-30% | 260-270A | 25-30C | 10-20% | 0.006388889 | 1.66111111 |
| 30-40% | 260-270A | 25-30C | 20-30% | 0.006388889 | 0.14694444 |
| 40-50% | 260-270A | 25-30C | 30-40% | 0.003333333 | 0.86666667 |
| 40-50% | 10-20A | 30-35C | 30-40% | 0.066666667 | 0.66666667 |
| 60-70% | 120-130A | 30-35C | 50-60% | 0.016666667 | 2 |
| 70-80% | 100-110A | 30-35C | 60-70% | 0.016666667 | 1.66666667 |
| 80-90% | 100-110A | 30-350 | 70-80% | 0.016666667 | 1.66666667 |
| 90-100% | 100-110A | 30-35C | 80-90% | 0.016666667 | 1.66666667 |
| 100-110% | -110 - -100A | 30-35C | 0-10% | 0.016666667 | -1.66666667 |
| 90-100% | -110 - -100A | 30-35C | 10-20% | 0.016666667 | -1.66666667 |
| 80-90% | -110 - -100A | 30-350 | 20-30% | 0.016666667 | -1.66666667 |
| 70-80% | -110 - -100A | 30-35C | 30-40% | 0.016666667 | -1.66666667 |
| 60-70% | -110 - -100A | 30-35C | 40-50% | 0.016666667 | -1.66666667 |
| 50-60% | -110 - -100A | 30-35C | 50-60% | 0.016666667 | -1.66666667 |
| 40-50% | -110 - -100A | 30-35C | 60-70% | 0.016666667 | -1.66666667 |
| 30-40% | -110 - -100A | 30-35C | 70-80% | 0.016666667 | -1.66666667 |
| 20-30% | 0-10A | 30-350 | 0-10% | 0.066666667 | -6.66666667 |

Ainsi, à titre d'exemple, on note dans le tableau 3 qu'entre 01h00 et 01h01, on observe respectivement les classes suivantes d'état de charge, d'intensité, de température et de profondeur de décharge : [0%,10%[, [0 A,10 A[, [25 °C,30 °C[, [0%,10%[.

Le tableau 3 ne comporte aucune autre entrée avec cette combinaison de classes de paramètres. On déduit donc du tableau 3 que pour cette combinaison de classes, la durée Δt est d'une minute, soit environ 0,01666667 heure. La quantité de charge transitée Qth correspondante est égale à environ 0,1666667 Ah.

On note également que plusieurs entrées du tableau 3, entre 01h01 et 01h10, comportent respectivement les classes suivantes d'état de charge, d'intensité, de température et de profondeur de décharge : [10%,20%[, [10 A,20 A[, [25 °C,30 °C[, [0%,10%[.

Comme ces entrées ont la même combinaison de classes, on groupe ces entrées de la manière illustrée dans le tableau 5. La durée Δt de l'entrée correspondant à cette opération de groupement est égale à 9 minutes, soit 0,15 heure. La quantité de charge transitée Qth correspondante est égale à 1,5 Ah.

Dans une étape suivante du procédé selon l'invention (étape 40), on peut créer à partir des entrées obtenues après l'opération de groupement une matrice de distribution temporelle et une matrice de distribution de quantité de charge transitée.

Les dimensions de ces matrices sont les quatre paramètres du profil de sollicitation. Chaque élément de ces matrices est caractérisé par une combinaison des classes des quatre paramètres. La matrice de distribution temporelle contient les temps cumulés correspondant à chaque combinaison de classes, la matrice de distribution de quantité de charge transitée contient les quantités de charge transitée correspondant à chaque combinaison de classes.

De préférence, les matrices sont créées par itérations successives des classes de grandeur de chaque paramètre. Ces itérations peuvent être indifféremment effectuées dans une pluralité d'ordres différents.

De préférence, les dimensions adressées en premier lieu dans la matrice sont les dimensions correspondant aux paramètres à la fois continus et ayant une influence notable sur le modèle de vieillissement considéré ; par exemple le SOC en premier lieu et la température en second lieu.

A titre d'exemple, on peut utiliser l'ordre suivant : on parcourt toutes les classes d'état de charge par ordre de valeurs croissantes ; pour chaque classe d'état de charge, on parcourt toutes les classes de température par ordre de valeurs croissantes ; pour chaque classe de température, on parcourt toutes les classes d'intensité par ordre de valeurs croissantes ; pour chaque classe d'intensité, on parcourt toutes les classes de profondeur de décharge par ordre de valeurs croissantes ; pour chaque classe de profondeur de décharge, on enregistre respectivement le temps cumulé et la quantité de charge transitée correspondant à la combinaison de classes de paramètres dans la matrice de distribution temporelle et dans la matrice de distribution de quantité de charge transitée.

Les matrices de distribution permettent avantageusement de faciliter la concaténation de plusieurs profils de sollicitation différents, obtenue en sommant les matrices de distribution correspondantes. On obtient alors un profil allégé de plusieurs sollicitations sans augmentation de volumes de données. Elles permettent également de minimiser la quantité de mémoire nécessaire pour le stockage des profils de sollicitation.

Dans une étape suivante du procédé selon l'invention (étape 50), on utilise la quantité de charge transitée et le temps cumulé pour calculer une intensité moyenne pour chaque entrée. On détermine également une valeur de paramètre pour chaque paramètre de chaque entrée.

L'intensité moyenne est obtenue selon l'équation *I* = *Qth*/Δ*t*, où Qth est la quantité de charge transitée et Δt le temps cumulé pour une entrée donnée.

Les valeurs des paramètres autres que l'intensité sont déterminées, pour chaque entrée, en réalisant la moyenne des bornes de l'intervalle des classes de paramètres correspondant à cette entrée.

Le tableau 6 représente les entrées du tableau 5 modifiées en remplaçant par exemple les classes des paramètres soit par l'intensité moyenne dans le cas de l'intensité, soit par la moyenne des bornes de l'intervalle de la classe concernée pour les autres paramètres.

A titre d'exemple, l'état de charge de la première entrée du tableau 6 est de 5%, c'est-à-dire la moyenne des bornes 0% et 10% de l'intervalle de la classe correspondante indiquée dans le tableau 5.

Alternativement, la borne inférieure ou la borne supérieure de chaque intervalle peut être utilisée en lieu et place de la moyenne de l'intervalle.

**[Tableau 6]**

| **Delta t (h)** | **Q (Ah)** | **SOC (%)** | **T (°C)** | **DOD (%)** | **I (A)** |
|---|---|---|---|---|---|
| 0.016666667 | 0.166666667 | 5 | 27.5 | 5 | 10 |
| 0.150 | 1.500 | 15 | 27.5 | 5 | 10 |
| 0.000555556 | 0.144444444 | 15 | 27.5 | 15 | 260 |
| 0.006388889 | 1.661111111 | 25 | 27.5 | 15 | 260 |
| 0.006388889 | 0.146944444 | 35 | 27.5 | 25 | 23 |
| 0.003333333 | 0.866666667 | 45 | 27.5 | 35 | 260 |
| 0.066666667 | 0.666666667 | 45 | 32.5 | 35 | 10 |
| 0.016666667 | 2 | 65 | 32.5 | 55 | 120 |
| 0.016666667 | 1.666666667 | 75 | 32.5 | 65 | 100 |
| 0.016666667 | 1.666666667 | 85 | 32.5 | 75 | 100 |
| 0.016666667 | 1.666666667 | 35 | 32.5 | 85 | 100 |
| 0.016666667 | -1.66666667 | 105 | 32.5 | 5 | -100 |
| 0.016666667 | -1.66666667 | 95 | 32.5 | 15 | -100 |
| 0.016666667 | -1.66666667 | 85 | 32.5 | 25 | -100 |
| 0.016666667 | -1.66666667 | 75 | 32.5 | 35 | -100 |
| 0.016666667 | -1.66666667 | 65 | 32.5 | 45 | -100 |
| 0.016666667 | -1.66666667 | 55 | 32.5 | 55 | -100 |
| 0.016666667 | -1.66666667 | 45 | 32.5 | 65 | -100 |
| 0.016666667 | -1.66666667 | 35 | 32.5 | 75 | -100 |
| 0.066666667 | -6.66666667 | 25 | 32.5 | 5 | -100 |

De préférence, les entrées obtenues sont ensuite ordonnées. Pour ce faire, les entrées sont en premier lieu ordonnées par ordre croissant des paramètres à la fois continus et ayant une influence notable sur le vieillissement considéré : il s'agit dans cet exemple du SOC et de la température. Comme visible dans le tableau 7, on ordonne en premier lieu les entrées par ordre croissant du SOC puis on ordonne les entrées par ordre croissant de température pour chaque valeur constante de SOC. On peut ensuite ordonner les entrées par ordre croissant des autres paramètres pris successivement, pour chaque valeur constante de SOC et de température.

Dans une étape suivante du procédé selon l'invention (étape 60), on calcule pour chaque entrée un temps total. Le temps total est égal à 0 pour la première entrée et, pour les entrées suivantes, est calculé par la somme de la durée Δt de l'entrée précédente et du temps total de l'entrée précédente.

On crée ensuite un profil allégé en associant les valeurs de paramètres de chaque entrée avec le temps total correspondant à cette entrée. La dernière entrée du profil allégé n'a pas de valeurs de paramètres définis.

Le profil allégé obtenu à partir des données du tableau 6 est illustré dans le tableau 7. Les valeurs de temps total dans le tableau 7 sont arrondies à la deuxième décimale.

A titre d'exemple, on note que le temps total de la première entrée est 0. Le temps total de la deuxième entrée est égal à la somme du temps total de la première entrée et de la durée correspondant à la première entrée, soit une minute ou environ 0,0167 heure. Le temps total de la troisième entrée est égal à la somme du temps total de la deuxième entrée, soit une minute, et de la durée correspondant à la deuxième entrée, soit neuf minutes, pour un temps total de dix minutes, soit environ 0,1667 heure.

**[Tableau 7]**

| **Time (h)** | **SOC (%)** | **T (°C)** | **DOD %** | **I (A)** |
|---|---|---|---|---|
| 0.0000 | 5 | 27.5 | 5 | 10 |
| 0.0167 | 15 | 27.5 | 5 | 10 |
| 0.1667 | 15 | 27.5 | 15 | 260 |
| 0.1672 | 25 | 27.5 | 15 | 260 |
| 0.1736 | 25 | 32.5 | 5 | -100 |
| 0.2403 | 35 | 27.5 | 25 | 23 |
| 0.2467 | 35 | 32.5 | 75 | -100 |
| 0.2633 | 45 | 27.5 | 35 | 260 |
| 0.2667 | 45 | 32.5 | 35 | 10 |
| 0.3333 | 45 | 32.5 | 65 | -100 |
| 0.3500 | 55 | 32.5 | 55 | -100 |
| 0.3667 | 65 | 32.5 | 55 | 120 |
| 0.3833 | 65 | 32.5 | 45 | -100 |
| 0.4000 | 75 | 32.5 | 65 | 100 |
| 0.4167 | 75 | 32.5 | 35 | -100 |
| 0.4333 | 85 | 32.5 | 75 | 100 |
| 0.4500 | 85 | 32.5 | 25 | -100 |
| 0.4667 | 95 | 32.5 | 85 | 100 |
| 0.4833 | 95 | 32.5 | 15 | -100 |
| 0.5000 | 105 | 32.5 | 5 | -100 |
| 0.5167 | NaN | NaN | NaN | NaN |

On obtient ainsi un profil allégé représentant une quantité de données fortement réduite par rapport au profil de sollicitation initial.

La simulation du vieillissement d'une batterie par la mise en oeuvre d'un modèle de vieillissement utilisant un profil allégé est accélérée par rapport à l'utilisation du profil initial, de par la réduction du nombre d'entrée, de même que les calculs d'estimation d'état de santé (SOH) d'une batterie.

De manière avantageuse, la mise en oeuvre d'une simulation de vieillissement permet de prédire une évolution des paramètres d'une batterie et de son état de santé. En fonction des résultats d'une simulation, il peut être déterminé par exemple à partir d'une prédiction de l'état de santé d'une batterie que cette batterie pourra être utilisée plus longtemps qu'une durée initialement prévue ou qu'une opération de remplacement doit être programmée.

On a illustré à la figure 2 une comparaison entre un profil de sollicitation obtenu suite à des tests menés sur une batterie, noté p1, et un profil allégé obtenu par un procédé selon l'invention appliqué au profil de sollicitation p1, noté p2.

La figure 2 est un graphique montrant l'évolution de l'état de santé (SOH) calculé à partir des paramètres de chaque profil en fonction du temps t, exprimé en jours. Le SOH est calculé selon les principes exposés dans la publication « Main Aging Mechanisms in Li Ion Batteries », Broussely, M., Ph. Biensan, F. Bonhomme, Ph. Blanchard, S. Herreyre, K. Nechev, et R.J. Staniewicz. Journal of Power Sources 146, n° 1-2 (août 2005): 90-96.

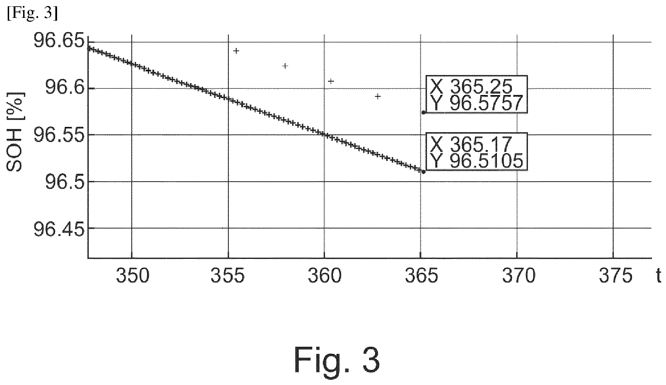

La figure 3 est une vue de détail de la figure 2, se concentrant sur les dernières entrées des profils p1 et p2. On constate que la différence du calcul de l'état de santé est minime : on obtient une valeur finale de 96,57% avec le profil initial contre 96,51% avec le profil allégé, soit une différence de 0,06 point de pourcentage.

Le profil initial p1 comporte 1365436 points de données et représente un poids de 14662 kilo-octets. Le profil allégé p2 comporte 2192 points de données et représente un poids de 6 kilo-octets.

Sur un même poste de travail utilisé par les inventeurs, l'obtention d'une valeur prédictive du SOH en fin de profil de sollicitation nécessite un temps de calcul de 36 minutes avec le profil initial, contre un temps de calcul de 3 secondes avec le profil allégé.

Grâce à l'invention, on obtient donc un profil qui, au prix d'une perte de précision minime, permet de fortement réduire l'impact du profil sur les capacités de stockage ainsi que sur les temps de calcul pour les opérations mettant en oeuvre le profil.

De manière avantageuse, durant un test de batterie de longue durée, par exemple un an, plusieurs profils de temps allégés peuvent être construits chacun sur une durée fixe inférieure à la durée du test, par exemple un mois, et ensuite être concaténés en un profil allégé unique. Ce profil allégé unique représente alors la sollicitation de la batterie sur la durée totale du test. On peut stocker ainsi des données de suivi de la batterie sur une durée relativement longue, tout en disposant d'une capacité réduite de stockage et/ou de moyens de calculs, qu'il devient alors possible par exemple d'embarquer sur un véhicule ou une puce électronique intégrée à la batterie.

Il est également possible de grouper les entrées d'une pluralité de profils initiaux de sollicitation de façon itérative, au fur et à mesure de l'obtention de ces profils initiaux. Cela permet de stocker les données des profils en optimisant l'espace de stockage requis. Le profil ainsi obtenu peut être utilisé dans un second temps pour construire le profil allégé et pour évaluer le vieillissement des batteries. Ce mode d'opération est avantageux par exemple dans le cadre de la surveillance de batteries : la collecte des profils initiaux et leur groupement peut être réalisée en continu, tandis que la construction du profil allégé peut être réalisée selon le choix d'un opérateur, par exemple au moment d'une opération de maintenance des batteries.

D'autres variantes et améliorations peuvent être prévues sans pour autant sortir du cadre de l'invention.

## Revendications

1. Procédé mis en oeuvre par ordinateur pour générer à partir d'un profil initial de sollicitation d'une batterie un profil allégé, le profil initial comportant une pluralité d'entrées renseignant sur l'évolution temporelle d'une pluralité de paramètres de la batterie,
le procédé comprenant les étapes consistant à :
(a) affecter à chaque valeur de chaque paramètre du profil initial une classe correspondant à un intervalle de valeurs possibles dudit paramètre ;
(b) grouper chaque ensemble formé d'entrées ayant les mêmes combinaisons de classes de paramètres en une entrée unique et déterminer, pour chaque entrée du profil obtenu, une durée correspondant à la somme des durées des entrées groupées ;
(c) redéfinir les valeurs des paramètres de chaque entrée, une valeur de paramètre étant redéfinie pour être égale à une valeur caractéristique de la classe correspondant à ladite valeur de paramètre ;
(d) créer le profil allégé en prenant pour chaque entrée du profil allégé les valeurs des paramètres du profil obtenu à l'étape (c) ainsi qu'un temps cumulé,
le temps cumulé de la première entrée étant initialisé à une valeur de référence et le temps cumulé de chaque entrée suivante étant déterminé par la somme de la durée correspondant à l'entrée précédant ladite entrée suivante et du temps cumulé de l'entrée précédant ladite entrée suivante.

2. Procédé selon la revendication précédente, la valeur caractéristique d'une classe pour un paramètre donné étant choisie parmi une borne inférieure de la classe, une borne supérieure de la classe, une moyenne de la borne inférieure et de la borne supérieure de la classe ou étant déterminée à partir des valeurs dudit paramètre donné comprises dans ladite classe.

3. Procédé selon l'une des revendications précédentes, comprenant entre l'étape (c) et l'étape (d) une étape (c1) consistant à créer une matrice de distribution temporelle en enregistrant la durée de chaque entrée en fonction des classes de chaque paramètre de ladite entrée.

4. Procédé selon l'une des revendications précédentes, les paramètres comprenant au moins un paramètre cumulatif, le procédé comprenant entre l'étape (a) et l'étape (b) une étape (a1) consistant à rééchantillonner le profil en cas de variation d'une classe de paramètre cumulatif supérieure à un seuil donné entre deux entrées consécutives.

5. Procédé selon une des revendications précédentes, les paramètres comprenant une intensité consommée ou produite par la batterie, le procédé comprenant en outre :
• avant l'étape (b), une étape (a2) consistant à calculer, pour chaque entrée, une valeur de quantité de charge transitée définie par la valeur de l'intensité de ladite entrée multipliée par la durée de ladite entrée ;
• entre les étapes (b) et (c), une étape (b1) consistant à déterminer, pour chaque entrée du profil obtenu suite à l'étape de groupement, la valeur de quantité de charge transitée correspondante.

6. Procédé selon la revendication précédente, comprenant en outre entre les étapes (c) et (d), une étape (c2) consistant à créer une matrice de distribution de quantité de charge transitée en enregistrant la valeur de quantité de charge transitée de chaque entrée en fonction des classes de chaque paramètre.

7. Procédé selon l'une des revendications 5 ou 6, dans lequel on calcule au cours de l'étape (c) une intensité moyenne pour chaque entrée à partir de la quantité de charge transitée et de la durée de ladite entrée.

8. Procédé selon l'une des revendications précédentes, les paramètres comprenant un état de charge de la batterie, une température de la batterie et une profondeur de décharge de la batterie.

9. Procédé selon la revendication 8, les entrées du profil obtenu à l'étape (b) étant ordonnées en parcourant en premier lieu les classes d'état de charge.

10. Procédé selon la revendication 9, les paramètres comprenant une intensité consommée ou produite par la batterie, les entrées du profil obtenu à l'étape (b) étant ordonnées en parcourant en second lieu les classes de température, puis les classes d'intensité, puis les classes de profondeur de décharge de la batterie.

11. Procédé selon l'une des revendications précédentes, comportant avant l'étape (a) une étape (a0) consistant à générer le profil de sollicitation initial, notamment par suivi des paramètres de la batterie lors d'une application industrielle ou lors d'un test comprenant des étapes de vieillissement en cyclage et de vieillissement calendaire.

12. Procédé selon l'une des revendications précédentes, dans lequel les étapes (a) et (b) sont appliquées à une pluralité de profils initiaux de sollicitation et les étapes (c) et (d) sont appliquées en une fois aux entrées uniques du profil obtenu suite à l'étape (b).

13. Procédé de simulation de vieillissement d'une batterie, dans lequel on génère une information relative à une prédiction du vieillissement de la batterie à partir d'un profil allégé obtenu par la mise en oeuvre du procédé selon l'une quelconque des revendications 1 à 12.

14. Produit programme d'ordinateur comportant un support informatique et, enregistrées sur ce support, des instructions lisibles par un processeur amenant ce dernier, lorsqu'exécutées, mettre en oeuvre le procédé selon l'une des revendications 1 à 12 pour obtenir un profil allégé.
